Europäisches Patentamt

European Patent Office

Office européen des brevets

(19)

(11) Numéro de publication : **0 350 393 B1**

(12) **FASCICULE DE BREVET EUROPEEN**

(45) Date de publication du fascicule du brevet :
**17.06.92 Bulletin 92/25**

(51) Int. Cl.⁵ : **H05K 5/00**

(21) Numéro de dépôt : **89401918.1**

(22) Date de dépôt : **04.07.89**

(54) **Boîtier pour le logement étanche en particulier de composants électriques ou électroniques.**

(30) Priorité : **07.07.88 FR 8809217**

(43) Date de publication de la demande :
**10.01.90 Bulletin 90/02**

(45) Mention de la délivrance du brevet :
**17.06.92 Bulletin 92/25**

(84) Etats contractants désignés :
**DE GB IT**

(56) Documents cités :
**EP-A- 0 156 298**
**DE-A- 3 439 624**
**DE-U- 7 205 740**
**FR-A- 1 354 661**
**GB-A- 2 115 084**

(73) Titulaire : **ROGER-ELEKTRONIKBAUTEILE GMBH**
**Zum Gerlen**
**W-6601 Saarbrücken-Ensheim (DE)**

(72) Inventeur : **Schwartz, Roman**
**Heimeltstrasse 18**
**W-6601 Ensheim-Saarbrücken (DE)**
Inventeur : **Schmitt, Horst**
**3, rue de la Gare**
**F-67260 Wolfskirchen (FR)**
Inventeur : **Henry, Jacques**
**29, rue du Brotsch Osterswiller**
**F-67700 Saverne (FR)**

(74) Mandataire : **Lerner, François et al**
**LERNER & BRULLE S.C.P. 5, rue Jules Lefèbvre**
**F-75009 Paris (FR)**

## Description

L'invention a pour objet un boîtier pour le logement étanche en particulier de composants électriques ou électroniques. Selon la première partie de la revendication 1. Un tel boîtier est décrit dans GB-A-2 115 084.

Dans les modes de réalisation classiquement utilisés, le joint est monté solidaire d'une partie du boîtier, par exemple le rebord convenablement conformé en concordance faisant saillie sur la paroi supérieure du fond du boîtier, et sa partie faisant saillie au-dessus du fond du boîtier est reçue à compression contre un rebord conformé en correspondance du couvercle. Différents problèmes se posent au niveau de la réalisation du joint, de sa bonne fixation sur le fond, et de la conformation judicieuse des profils du rebord du couvercle pour assurer une bonne étanchéité à la suite de la compression du joint généralement constitué en un matériau élastomère.

L'invention permet de résoudre de façon originale les problèmes d'étanchéité sus-mentionnés entre fond et couvercle de boîtier, tout en simplifiant considérablement l'outillage permettant la fabrication du boîtier.

A cet effet, un boîtier pour le logement étanche en particulier de composants électriques ou électroniques comprenant un fond et un couvercle montés serrés de façon étanche l'un contre l'autre au moyen d'un joint et dans lequel les rebords venant porter l'un contre l'autre, en enserrant le joint, du fond et du couvercle sont constitués de façon identique est caractérisé par les caractéristiques énoncées dans la seconde partie de la revendication 1. Les rebords du fond et du couvercle sont formés avec des feuillures ou rainures dans lesquelles s'engage le joint d'étanchéité précité qui se présente comme un profilé de section compatible à celle des deux feuillures ou rainures appliquées l'une contre l'autre du fond et du couvercle.

Grâce à ces moyens on comprend que le fond et le couvercle pourront être fabriqués, par exemple en matière moulée, à partir du même moule, à partir du moment où les rebords de ces deux parties sont identiques. Et de surcroît, en prévoyant simplement des hausses de l'outil de moulage il sera possible de constituer des parties, fonds ou couvercles de hauteur variable permettant la fabrication à partir d'un seul moule et de quelques hausses de faible coût toute une gamme de hauteurs de boîtier.

De surcroît la conformation particulière du joint d'étanchéité qui joue le rôle d'un segment d'étanchéité, améliore l'étanchéité et facilite la fabrication et l'insertion de ce joint qui s'engage indifféremment dans le fond et/ou dans le couvercle sans devoir être fixé sur l'une des parties ou sur l'autre.

Selon une autre caractéristique, l'aspect modulaire des boîtiers est mis à profit par l'utilisation de moyens tels que des rails de guidage prévus par exemple dans les angles des boîtiers permettant de recevoir des plaques de montage de dimensions adaptables pour le support dans le boîtier de cartes imprimées ou autres éléments plats électroniques.

L'invention et sa mise en oeuvre apparaîtront plus clairement à l'aide de la description qui va suivre faite en référence aux dessins annexés donnant uniquement à titre d'exemple un mode de mise en oeuvre.

Dans ces dessins :

– la figure 1 est une vue en perspective éclatée montrant un boîtier conforme à l'invention avec ses différents éléments dans leur positionnement respectif,

– la figure 2 est une vue de dessus à plus grande échelle du fond du boîtier de la figure 1,

– les figures 3 et 4 sont des vues en coupe faites respectivement selon les plans III-III et IV-IV de la figure 2,

– la figure 5 est une vue à plus grande échelle faite en coupe selon le plan V-V de la figure 2,

– la figure 6 est une vue en coupe avec arrachement au niveau d'une vis de jonction assurant la réunion du fond et du couvercle du boîtier,

– la figure 7 est une vue en plan du joint d'étanchéité,

– la figure 8 est une vue à plus grande échelle du détail entouré VIII à la figure 7,

– la figure 9 est une vue en coupe à plus grande échelle faite au niveau du plan IX-IX de la figure 8,

– la figure 10 montre à plus grande échelle et en coupe médiane un bouchon d'obturation du boîtier,

– la figure 11 est une vue en coupe faite à plus grande échelle selon le plan XI-XI de la figure 2,

– la figure 12 est une vue en plan d'une plaque de support d'éléments utilisable dans le coffret de l'invention,

– la figure 13 est une vue en coupe faite selon le plan XIII-XIII de la figure 12,

– la figure 14 est une vue de la plaque de la figure 12 mais selon sa face opposée,

– la figure 15 est une vue en coupe faite selon le plan XV-XV de la figure 14.

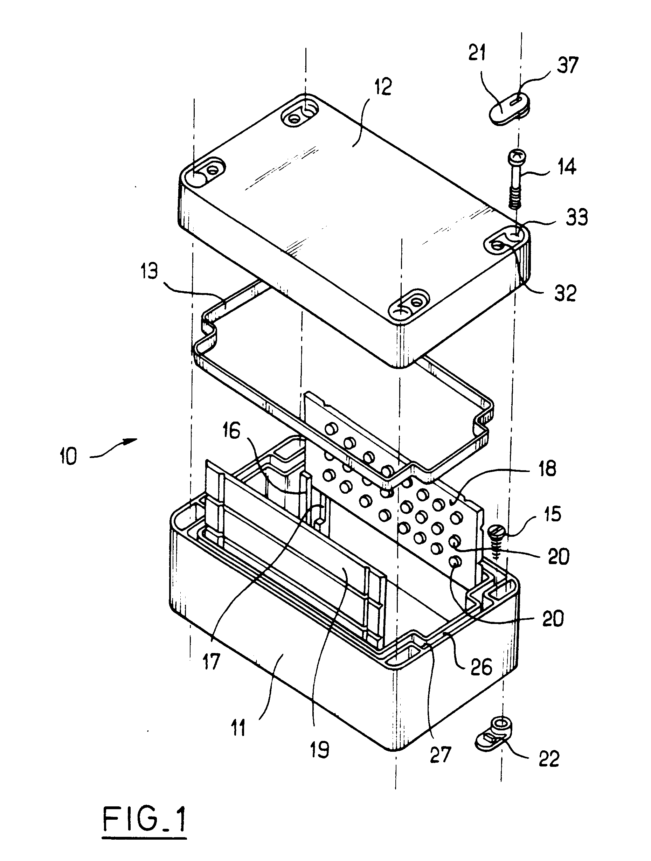

Selon le mode de réalisation illustré aux dessins et en se reportant tout d'abord à la figure 1 on aperçoit un boîtier désigné dans son ensemble 10 comprenant essentiellement un fond 11 et un couvercle 12 dont l'étanchéité dans la position de montage est assurée par un joint intermédiaire 13. Le couvercle 12 est fixé sur le fond 11 au moyen de quatre vis telle que la vis repérée 14 d'assemblage entre les deux parties 11 et 12. Le fond 11 peut être fixé lui-même par exemple à une paroi au moyen d'autres vis tel que repéré en 15 et comme il apparaîtra plus clairement plus loin. Le boîtier 10 comporte des moyens formant glissières ou rails de guidage tels qu'on les aperçoit dans un angle en 16 et 17 permettant de recevoir des plaques 18, 19 qui permettront le support d'éléments tels que des cartes imprimées ou autres éléments plats électroniques qui seront engagés entre les plaques 18 et 19 sur des rangées de pions alignés 20.

A la même figure 1 on aperçoit en 21, 22 des bouchons venant obturer en se verrouillant à force sur le couvercle et sur le fond des orifices pour le passage des vis 14, 15.

Le coffret ayant été ainsi montré dans son ensemble, on se reportera aux figures suivantes pour décrire plus en détail sa constitution et ses fonctions d'utilisation.

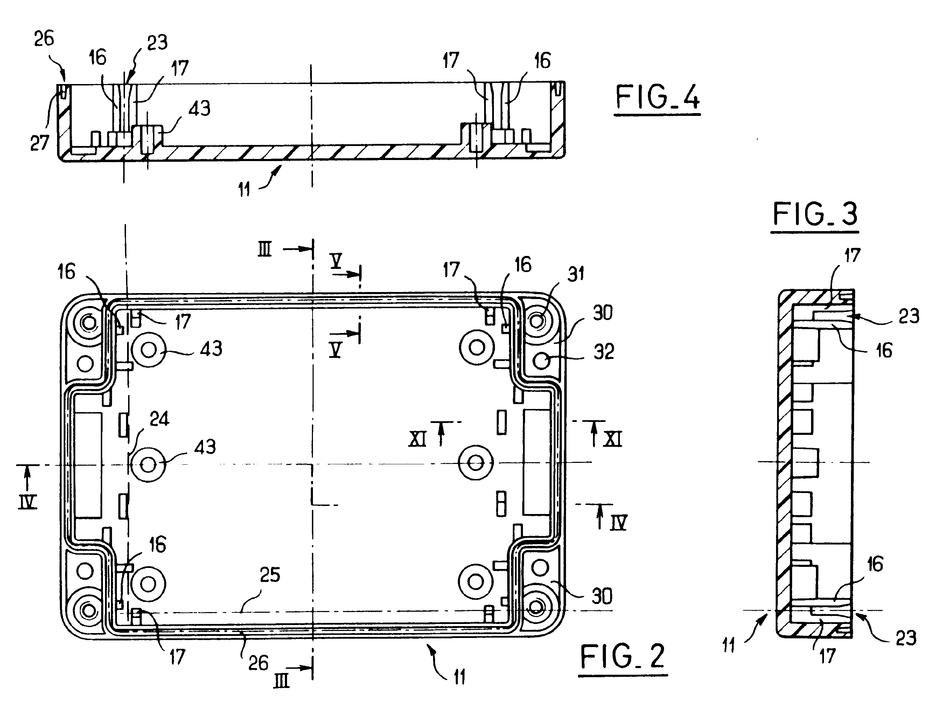

En faisant tout d'abord référence aux figures 2 à 4 on aperçoit de façon plus précise le positionnement des rails de guidage 16, 17 permettant l'engagement et le maintien des plaques de support telles que 18 et 19 qui s'engagent dans les passages 23 de largeur correspondante formés entre ces rails, que la plaque soit présentée dans la direction de la largeur du boîtier dans le plan repéré 24 à la figure 2 ou dans la direction de la longueur du boîtier dans le plan repéré 25 à cette même figure.

Aux figures 2 à 4 on aperçoit également clairement la conformation du rebord supérieur 26 du fond 11 se présentant avec une feuillure ou rainure 27 sensiblement en U dans l'ouverture duquel pourra venir s'engager le joint d'étanchéité 13. Et comme indiqué précédemment le rebord inférieur correspondant du couvercle 12 sera conformé de façon identique, de sorte qu'il n'a pas été représenté.

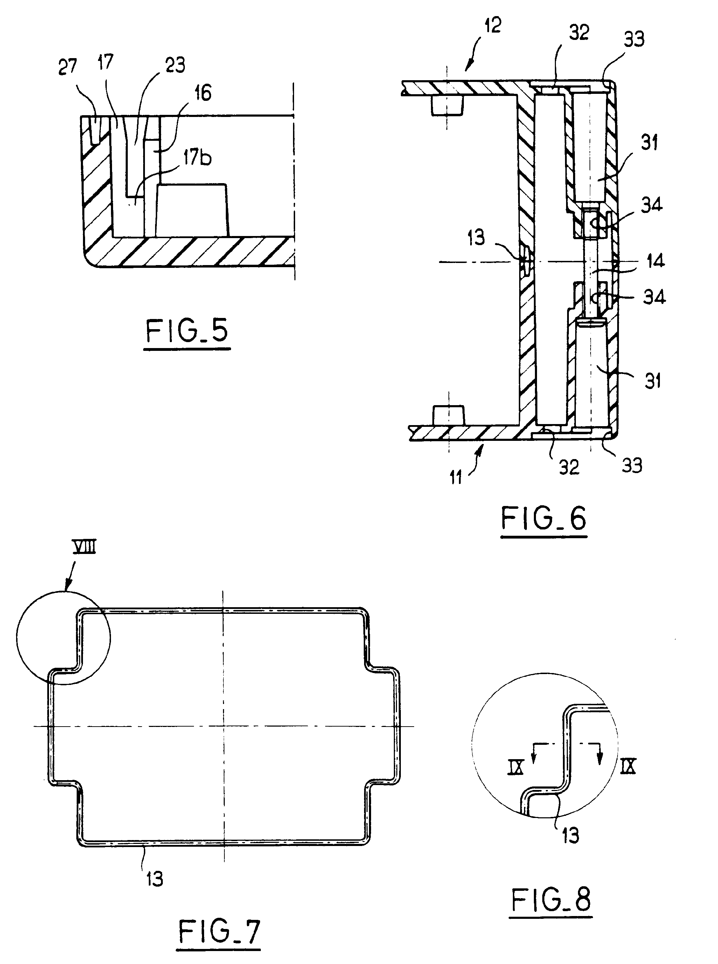

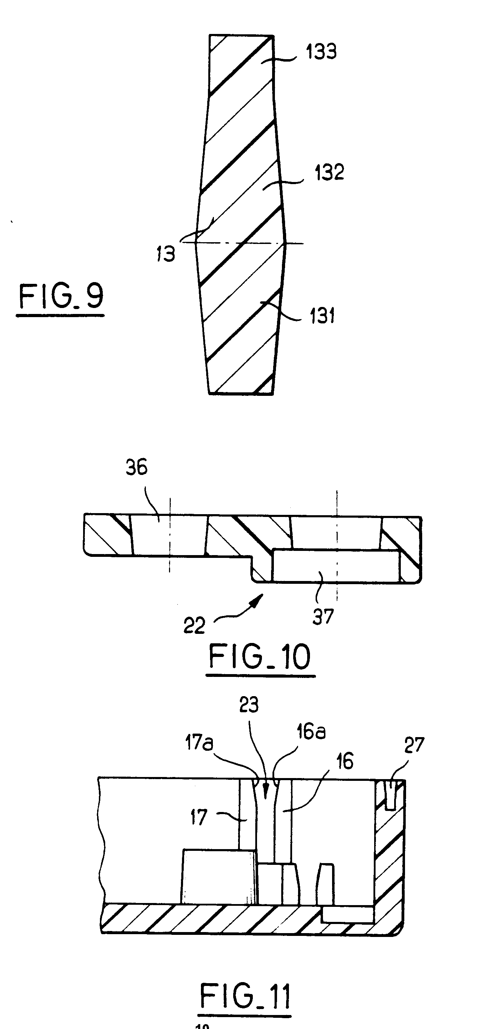

En se reportant aux figures 7, 8 et 9 on voit plus en détail la configuration du joint 13 d'étanchéité formant segment à section en profilé sensiblement en I plat allant en s'élargissant légèrement vers la partie médiane pour assurer une bonne étanchéité et jonction pour engagement dans les rainures 27 coopérantes du fond et du couvercle. Dans l'exemple illustré et comme il apparaît à la figure 9 le profilé a sensiblement la forme en section de deux troncs de cônes inversés à faible angle au sommet 131, 132 se terminant par une section rectangulaire 133. La conformation du joint 13 et des rainures 27 coopérantes du fond et du couvercle assurent une bonne étanchéité et une bonne jonction des deux parties du boîtier.

En se reportant aux figures 5 et 11, on a illustré à plus grande échelle les parties d'angle précédemment décrites dans lesquelles on retrouve la rainure 27 de logement du joint d'étanchéité et les rails de guidage 16, 17 ménageant entre eux le passage 23 pour l'introduction et le maintien en tiroir des plaquettes 18, 19. A ces figures on aperçoit également que pour faciliter l'engagement des plaquettes 18, 19 les rails 16, 17 de guidage sont chanfreinés à leur partie supérieure 16a, 17a légèrement en V ouvert à environ 10°, et de la même façon les rainures 27 sont légèrement ouvertes pour coopérer avec le joint conformé 13 de façon semblable et comme il apparaît plus clairement à la figure 9.

A la figure 5 on aperçoit également que les rails de guidage 17 comportent à leur base une partie élargie 17b de faible hauteur limitant l'engagement des plaques de supports 18, 19 pour qu'elles ne viennent pas jusqu'à la paroi intérieure de fond du boîtier.

En se reportant plus précisément aux figures 2 et 6, on aperçoit dans les angles des boîtiers, notamment lorsque le boîtier a une section polygonale, et à l'extérieur de la paroi de confinement du volume intérieur du boîtier, des passages 30 dans lesquels sont formés deux séries d'orifices respectivement 31 et 32. Les orifices 31 débouchent sur la paroi de dessus du couvercle 12 ou de dessous du fond 11 au niveau d'une ouverture 33 par laquelle on peut engager une vis 14 qui assurera la jonction des deux parties 11, 12 du boîtier. A cet effet les orifices 31 comportent des parties filetées 34 dans lesquelles peuvent se viser les vis 14.

Les orifices 32 traversent simplement la paroi de dessus du couvercle 12 ou de dessous du fond 11 pour permettre l'engagement d'une vis telle que 15 (figure 1) pour la fixation du coffret à une paroi (non représentée) contre laquelle est appliquée le fond ou le couvercle du boîtier.

A la figure 6 il apparaît que le fond et le couvercle sont formés de façon identique et ont même dimension.

A la figure 1 le couvercle 12 apparaît comme moins profond que le fond 11. Mais l'on comprend que ces deux éléments peuvent être obtenus à partir du même moule pourvu seulement d'une hausse selon des techniques de moulage parfaitement classiques.

En se reportant aux figures 1 et 10, il apparaît que les orifices 32, 33 peuvent être obturés par des bouchons 21 ou 22. Le bouchon 22 de la figure 10 est un bouchon de dessous qui comporte un orifice 36 pour le passage des vis de fixation 15, tandis que le bouchon 21 est dépourvu d'un tel orifice, dans la mesure où la fixation du boîtier n'a pas été prévue par son couvercle. La fente 37 formée dans le bouchon 22 ou 21 permet de sortir le bouchon au moyen de la lame d'un tourne-vis si l'on veut avoir accès aux vis telles que 14 ou 15. Le bouchon est conformé de façon à venir s'appliquer et se verrouiller sur l'orifice d'accès 33 ou 32 qu'il obture.

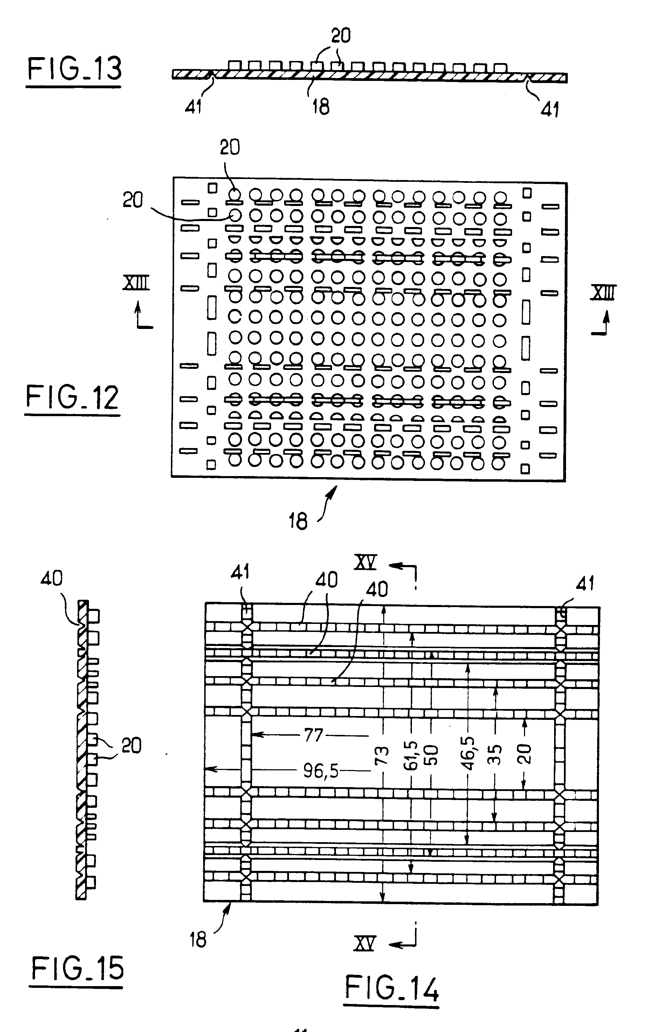

En se reportant aux figures 12 à 15 on a illustré plus précisément la conformation des plaques de supports et cartes imprimées ou autres éléments plats électroniques (non représentés) qui seront logés dans le boîtier.

Comme indiqué précédemment, ces plaques planes viennent se glisser comme des tiroirs plats dans les rails de guidage 16, 17 en correspondance prévus dans les angles de boîtier.

Pour le support des éléments plats électroniques, les plaques comportent sur une de leur face des pions 20 alignés en rangées et colonnes orthogonales parallèles aux côtés des plaques laissant entre elles des passages étroits pour le support de cartes imprimées qui pourront donc également être engagées entre deux cartes supports se faisant face 18, 19 (figure 1) à la manière d'un tiroir supporté par ses glissières.

Dans l'exemple illustré, l'autre face des plaquettes est conformée avec les lignes de moindre résistance constituée par des saignées en V telles que 40, 41. Dans l'exemple illustré, deux saignées 41 sont prévues aux extrémités longitudinales de la plaque à une distance qui correspond précisément à la largeur du boîtier. Si l'on casse les plaques 18, 19 le long des lignes 41, on obtient des plaques de moins larges dimensions pouvant être orientées dans le sens opposé à celui illustré à la figure 1, c'est- à-dire parallèlement aux petits côtés du boîtier toujours dans les rails du guidage 16, 17.

Dans le sens de la largeur de la plaque plusieurs lignes de faible résistance 40 sont prévues à des espacements divers. Ces espacements sont calculés pour qu'ils correspondent aux profondeurs des différents boîtiers pouvant être constitué à partir de couvercles 12 et de fonds 11 de hauteurs diverses. Ainsi, une même plaquette standard pourra servir indifféremment pour n'importe quelle hauteur de boîtier constitué par n'importe quel jeu de couvercle et fond et elle pourra être orientée aussi bien dans le sens longitudinal que dans le sens transversal du boîtier.

Bien entendu, l'invention n'est nullement limitée au mode de réalisation illustré et décrit qui n'a été donné qu'à titre d'exemple. Ainsi, le boîtier peut recevoir divers perfectionnements plus au moins classiques tels par exemple que des pions de fixation 43 (figure 2) sur la paroi interne du boîtier pour recevoir une plaque support d'élément qui peut être vissée sur ces pions.

De même, bien qu'on ait représenté le boîtier avec une forme rectangulaire, d'autres formes sont envisageables polygonales ou circulaires par exemple, bien que la forme rectangulaire soit généralement la plus pratique, en particulier pour le positionnement et l'orientation des plaques de support telles que 18 et 19.

## Revendications

1. Boîtier pour le logement étanche en particulier de composants électriques ou électroniques comprenant un fond (11) et un couvercle (12) montés serrés de façon étanche l'un contre l'autre au moyen d'un joint (13), et dans lequel les rebords (26) venant porter l'un contre l'autre, en enserrant le joint, du fond et du couvercle, sont constitués de façon identique caractérisé en ce que lesdits rebords (26), formés à partir d'un même outil de formage, comportent des feuillures ou rainures (27) à section sensiblement en U dans lesquelles s'engage le joint d'étanchéité précité (13) qui se présente comme un profilé de section compatible avec celle des deux feuillures ou rainures appliquées l'une contre l'autre du fond et du couvercle en présentant une section sensiblement en I plat allant en s'élargissant légèrement vers sa partie médiane.

2. Boîtier selon la revendication 1 caractérisé en ce que pour la jonction du fond (11) et du couvercle (12) sont formés à la périphérie, notamment dans les angles lorsque le boîtier a une section polygonale, et à l'extérieur de la paroi fermant le volume du boîtier, des orifices (31) débouchant sur la paroi du fond ou du couvercle comportant des parties filetées (34) pour l'assemblage au moyen de vis du fond et du couvercle.

3. Boîtier selon la revendication 1 ou 2 caractérisé en ce qu'il est prévu pour la jonction du fond (11) et du couvercle (12) à la périphérie, notamment dans les angles lorsque le boîtier a une section polygonale et à l'extérieur de la paroi formant le volume du boîtier, des orifices (32) débouchant sur la paroi du fond ou du couvercle pour la fixation du coffret à une paroi.

4. Boîtier selon la revendication 2 ou la revendication 3 caractérisé en ce qu'il est prévu des bouchons (21, 22) ou chapeaux se verrouillant à force obturant les orifices précités.

5. Boîtier selon l'une des revendications précédentes caractérisé en ce qu'étant de section rectangulaire, il est prévu à l'intérieur du boîtier au moins deux paires de rails de guidage (16, 17) formés dans les angles par des nervures se faisant face dans lesquels on peut introduire à coulissement des plaques (18, 19) supports d'éléments de section sensiblement rectangulaire.

6. Boîtier selon la revendication 5 caractérisé en ce que lesdites plaques rectangulaires planes (18, 19) sont pourvues sur une face de pions (20) alignés en rangées et colonnes orthogonales parallèles aux côtés des plaques laissant entre elles des passages étroits pour le support de cartes imprimées ou autres éléments plats électroniques devant être logés dans le boîtier, lesdites plaques étant formées avec des lignes de moindre résistance (40, 41) également disposées en un réseau orthogonal parallèle aux côtés des cartes et distantes entre elles de longueurs correspondant aux dimensions respectivement des longueurs, largeurs et profondeurs des boîtiers mesurées au niveau des rails précités de guidage et de maintien desdites plaques (18, 19).

## Patentansprüche

1. Gehäuse für die dicht verschlossene Lagerung insbesondere von elektrischen oder elektronischen Bauteilen, mit einem Boden (11) und einem Deckel (12), die fest und dichtend mittels einer Verbindung (13) gegeneinander angebracht sind, bei welchem die Randleisten (26) unter Umfassung der Verbindung das eine Teil von Boden und Deckel gegen das andere halten und identisch aufgebaut sind, dadurch gekennzeichnet, daß die Randleisten (26), von demselben Formwerkzeug ausgehend, gebildet sind und Fugen oder Rillen (27) mit einem im wesentlichen U-förmigen Querschnitt haben, in welche die Dichtigkeitsverbindung (13) eingreift, die ein Querschnittsprofil passend zu dem der zwei Fugen oder Rillen hat, wobei die Fugen oder Rillen vom Boden und Deckel gegeneinander angebracht sind und einen Querschnitt eines im wesentlichen platten I bilden, welches sich zu seinem Mittelteil leicht verbreitert.

2. Gehäuse nach Anspruch 1, dadurch gekennzeichnet, daß für die Verbindung des Bodens (11) und des Deckels (12) am Umfang, insbesondere in den Ecken, wenn das Gehäuse einen polygonalen Querschnitt hat, und außerhalb der Wand, welche den Inhalt des Gehäuses umschließt, Öffnungen (31) gebildet sind, die in die wand des Bodens oder des Deckels münden und schraubbare Teile (34) für den Zusammenbau von Boden und Deckel mittels Schrauben aufweisen.

3. Gehäuse nach Anspruch 1 oder 2, dadurch gekennzeichnet, daß für die Verbindung des Bodens (11) und des Deckels (12) am Umfang, insbesondere in den Ecken, wenn das Gehäuse einen polygonalen Querschnitt hat, und außerhalb der Wand, welche den Inhalt des Gehäuses bildet, Öffnungen (32) vorgesehen sind, welche in die wand des Bodens oder des Deckels für die Befestigung des Behälters an einer Wand münden.

4. Gehäuse nach Anspruch 2 oder Anspruch 3, dadurch gekennzeichnet, daß Abschlüsse (21, 22) oder Abdeckungen vorgesehen sind, die sich mit Kraft unter Verschließen der genannten Öffnungen verriegeln.

5. Gehäuse nach einem der vorhergehenden Ansprüche, dadurch gekennzeichnet, daß bei rechteckigem Querschnitt im Inneren des Gehäuses mindestens zwei paar Führungsschienen (16, 17) vorgesehen sind, die in den Ecken durch Rippen gebildet sind, die sich gegenüberliegen und in welche man unter Gleiten Trägerplatten (18, 19) für die Elemente von im wesentlichen rechteckigem Querschnitt einführen kann.

6. Gehäuse nach Anspruch 5, dadurch gekennzeichnet, daß die rechteckigen, ebenen Platten (18, 19) auf einer Seite mit Pionen (20) versehen sind, die in senkrecht zueinander angeordneten Reihen und Spalten parallel zu den Seiten der Platten ausgerichtet sind, wobei sie zwischen sich enge Durchgänge belassen für die Halterung von Leiterplatten oder anderen flachen elektronischen Elementen, die in dem Gehäuse angeordnet werden müssen, wobei die Platten mit Leitungen von geringem Widerstand (40, 41) gebildet sind, die gleichermaßen in einem orthogonalen Netz angeordnet sind parallel zu den Seiten der Karten, und wobei sie um Längen entfernt voneinander angeordnet sind, welche den Abmessungen der Längen, Breiten bzw. Tiefen der Gehäuse entsprechen, die auf der Höhe der vorgenannten Schienen für die Führung und Halterung der Platten (18, 19) gemessen sind.

## Claims

1. A casing for the sealing-tight accommodation of in particular electrical or electronic components comprising a base (11) and a cover (12) mounted to be fastened one against the other in sealing-tight fashion by means of a packing (13) and in which the returned edges (26) which bear one against the other, clamping the packing, to close the base and the cover, are constituted in identical fashion, characterised in that the said returned edges (26) formed by one and the same forming tool comprise grooves (27) of substantially U-shaped cross-section in which the aforementioned sealing-tight packing (13) engages, having a cross-sectional profile compatible with that of the two grooves which are applied one against the other and which are part of the base and the cover, having a substantially flat I-shaped cross-section which widens out slightly towards its middle portion.

2. A casing according to claim 1, characterised in that for the junction of the base (11) and of the cover (12) there are formed on the periphery, particularly in the corners when the casing has a polygonal cross-section and on the outside of the wall closing the space of the casing, orifices (31) which open out on the wall of the base or of the cover, comprising screwthreaded parts (34) for assembly of the base and of the cover by means of screws.

3. A casing according to claim 1 or 2, characterised in that for connection of the base (11) and of the cover (12) to the periphery, particularly in the corners when the casing is of polygonal cross-section and on the outside of the wall forming the space of the casing, there are orifices (32) which open out into the wall of the base or of the cover for fixing of the cabinet to a wall.

4. A casing according to claim 2 or claim 3, characterised in that stoppers (21, 22) or caps are provided which are force-fitted so that they occlude the aforesaid orifices.

5. A casing according to one of the preceding claims, characterised in that being of rectangular cross-section there are inside the casing at least two pairs of guide rails (16, 17) formed in the corners by ribs which face each other and into which it is possible to introduce sliding plates (18, 19) which support elements of substantially rectangular cross-section.

6. A casing according to claim 6, characterised in that the said flat rectangular plates (18, 19) are provided on one face with studs (20) aligned in rows and columns at right-angles and parallel with the sides of the plates leaving between them narrow passages for supporting printed cards or other flat electronic elements which have to be accommodated within the casing, the said plates being formed with lines of lesser resistance (40, 41) which are likewise disposed in a right-angled network parallel with the sides of the cards and spaced apart by lengths corresponding to the respective dimensions of the lengths, widths and depths of the casings measured at the level of the aforesaid rails for guiding and supporting the said plates (18, 19).

FIG.1

7

FIG_3

FIG_4

FIG_2

FIG_5

FIG_6

FIG_7

FIG_8

FIG.9

FIG_10

FIG_11

FIG.13

FIG.12

FIG.15

FIG.14

77
96,5
73
61,5
50
46,5
35
20